Europäisches Patentamt

European Patent Office

Office européen des brevets

(11) Veröffentlichungsnummer: **0 520 243 A2**

# (12) EUROPÄISCHE PATENTANMELDUNG

(21) Anmeldenummer: **92109758.0**

(22) Anmeldetag: **10.06.92**

(51) Int. Cl.⁵: **H05K 1/05**

(30) Priorität: **24.06.91 DE 4120799**

(43) Veröffentlichungstag der Anmeldung:
**30.12.92 Patentblatt 92/53**

(84) Benannte Vertragsstaaten:
**DE FR GB IT NL SE**

(71) Anmelder: **SIEMENS AKTIENGESELLSCHAFT**
**Wittelsbacherplatz 2**
**W-8000 München 2(DE)**

(72) Erfinder: **Kammermaier, Johann, Dr.**

**Verstorben(DE)**
Erfinder: **Birkle, Siegfried, Dr.**
**Veit-Stoss-Strasse 46**
**W-8552 Höchstadt(DE)**

(54) **Metallkernleiterplatte.**

(57) Eine Metallkernleiterplatte mit einer wärmeableitenden Isolierschicht ist dadurch gekennzeichnet, daß die Isolierschicht eine plasmaabgeschiedene Schicht aus amorphem wasserstoffhaltigem Kohlenstoff (a-C:H) ist.

EP 0 520 243 A2

Die Erfindung betrifft eine Metallkernleiterplatte mit einer wärmeableitenden Isolierschicht.

Mit der steigenden Packungsdichte von elektronischen Bauelementen in Hybridschaltungen wird eine verbesserte Wärmeableitung des verwendeten Trägermaterials, insbesondere von Leiterplatten, erforderlich, um eine funktionsschädigende und lebensdauerverkürzende Erwärmung dieser Bausteine zu vermeiden. An das Trägermaterial werden dabei insbesondere folgende, sich zum Teil widersprechende Anforderungen gestellt:

- Es wird ein geringer punktueller, d.h. auf die Fläche des Bauelements bezogener wärmewiderstand R ≦ 3 K/W der Leiterplatte gefordert, damit die Temperaturerhöhung - bei einer Verlustwärme bis zu 15 W - unter 50 K bleibt; der wärmewiderstand ist dabei definiert als R = d/λ.F (mit d = Dicke, λ = Wärmeleitzahl und F = Fläche).
- Der Isolationswiderstand des Leiterplattenmaterials soll ≧ $10^{12}$ Ω.cm betragen, bei einem Klima mit 92 % relativer Luftfeuchte ≧ $10^8$ Ω.cm (bei Raumtemperatur), um eine ausreichende elektrische Entkoppelung der auf unterschiedlichem Potential liegenden Leitbahnen sowie eine Durchschlagsfestigkeit bei Prüfspannungen von 500 V bzw. Stoßspannungen von 2 kV zu gewährleisten.
- Es müssen haftfeste Leitbahnstrukturen und maßhaltige Bohrungen zur Einführung der Kontaktstifte bei automatischer Bestückung der Bauelemente erzeugt werden können.

Um diese Forderungen zu erfüllen, werden sogenannte Metallkernleiterplatten eingesetzt; diese Leiterplatten stellen eine Weiterentwicklung der für die Hybridtechnik zunächst verwendeten Leiterplatten aus glasfaserverstärktem Epoxidharz dar. Die Metallkernleiterplatten weisen - im Unterschied zu konventionellen Leiterplatten - einen metallischen Kern, insbesondere aus Aluminium oder Stahl, mit einer Dicke ≧ 1 mm auf und sind oberflächlich (ein- oder beidseitig) sowie in den Wandungen der Bohrungen mit einer Isolierschicht aus Kunststoff versehen, die durch Wirbelsintern aufgebracht werden kann (siehe dazu beispielsweise: "Der Elektriker", 17. Jahrg. (1978), Seite 192, und "Galvanotechnik", Bd. 78 (1987), Seite 1645). Aus der EP-PS 0 048 406 sind wärmeableitende Leiterplatten mit einer Kernplatte aus elektrisch leitfähigem Werkstoff bekannt, die als Isolierschicht eine Galvano-Aluminium-Eloxalschicht mit einer Dicke von 10 bis 80 μm aufweisen.

Bezüglich der Wärmeableitfähigkeit sind mit Kunststoff (Dicke: ca. 200 μm) beschichtete Metallkernleiterplatten mit einem Wärmewiderstand von etwa 9 K/W, bei einer Fläche von 1 cm², konventionellen Leiterplatten aus glasfaserverstärktem Epoxidharz, deren Wärmewiderstand - bei 1 cm² Fläche - etwa 70 K/W beträgt, deutlich überlegen. Sie stellen in dieser Hinsicht aber keine Alternative zu den teuren Aluminiumoxidkeramik-Substraten dar, deren Wärmewiderstand, einschließlich der Wärmeübergänge, pro 1 cm² nur ca. 0,5 K/W beträgt. Außerdem macht die erforderliche Einhaltung der Maßhaltigkeit der gebohrten bzw. gestanzten Kontaktlöcher in der Metallkernleiterplatte eine Nachbearbeitung nach der Kunststoffbeschichtung erforderlich.

Metallkernleiterplatten mit Isolierschichten aus eloxiertem Galvano-Aluminium weisen zwar einen ähnlich niedrigen Wärmewiderstand wie Aluminiumoxidkeramik-Substrate auf (ca. 0,4 K/W bei 1 cm²), sie sind aber erst nach dem Verschließen der in der Eloxalschicht vorhandenen Poren mittels Kunststoff einem chemischen Metallisierungsvorgang zugänglich. Andernfalls löst sich nämlich die nur ca. 1 bis 2 μm dicke Barriereschicht in dem zur Kontaktlochmetallisierung dienenden chemisch aggressiven Metallisierungsbad auf, so daß auch eine Metallisierung des Metallkerns erfolgt. Außerdem neigt die Eloxalschicht an den Kanten der Leiterplatte und an den Rändern der Bohrungen - wegen der hohen mechanischen Spannungen in der Schicht - zur Rißbildung, wodurch die Schicht in diesen Bereichen die Isolierwirkung verliert.

Aufgabe der Erfindung ist es, Metallkernleiterplatten mit einer wärmeableitenden Isolierschicht in der Weise auszugestalten, daß sie sämtliche der an sie gestellten Forderungen in hohem Maße erfüllen.

Dies wird erfindungsgemäß dadurch erreicht, daß die Isolierschicht eine plasmaabgeschiedene Schicht aus amorphem wasserstoffhaltigem Kohlenstoff (a-C:H) ist.

Amorpher wasserstoffhaltiger Kohlenstoff, kurz a-C:H, ist eine Kohlenstoffmodifikation, bei der ein amorphes Kohlenstoffnetzwerk vorliegt. Dieses Material wird wegen seiner großen mechanischen Härte, die eine hohe Verschleißfestigkeit bedingt, auch als diamantähnlicher Kohlenstoff bezeichnet. Im a-C:H weisen die Kohlenstoffatome überwiegend $sp^3$- und zu einem geringeren Anteil $sp^2$-Bindungen auf, wobei der gebundene Wasserstoff (H/C-Verhältnis bis ca. 0,6) strukturstabilisierend wirkt.

Aufgrund seiner amorphen Struktur kann a-C:H sehr homogen abgeschieden werden, so daß Fehlstellen, pin-holes usw. nicht auftreten können. Die Haftung von a-C:H-Schichten auf Metallen wie Aluminium, Eisen und Nickel ist sehr gut, da diese Metalle carbidbildend sind. Der spezifische elektrische Widerstand von a-C:H kann auf Werte > $10^{12}$ Ω.cm eingestellt werden, und die elektrische Durchschlagsfestigkeit dieses Materials beträgt > 150 V/μm, so daß bereits mit einer ca. 5 μm dicken a-

C:H-Schicht die Forderungen hinsichtlich Isolationswiderstand und Durchschlagsfestigkeit vollständig erfüllt werden können.

Amorpher wasserstoffhaltiger Kohlenstoff weist ferner den Vorteil auf, daß er gegen Chemikalien, insbesondere Säuren und Laugen, inert ist und - aufgrund eines niedrigen $H_2O$-Permeationskoeffizienten ($\leq 10^{-13}$ m²/s) - auch eine hohe Feuchtesperrwirkung aufweist. Die Wärmeleitfähigkeit von a-C:H ist > 1 W/m.K. Mit einer ca. 5 μm dicken a-C:H-Schicht kann deshalb der auf eine Fläche von 1 cm² bezogene Wärmewiderstand - bei Berücksichtigung sämtlicher Wärmeübergänge zwischen Bauelement und Metallkern der Leiterplatte - auf < 0,2 K/W reduziert werden.

Bei der Metallkernleiterplatte nach der Erfindung ist die wärmeableitende und elektrisch isolierende Isolierschicht aus a-C:H, die - wie bereits ausgeführt - vorzugsweise eine Dicke bis zu etwa 5 μm aufweist, ein- oder beidseitig auf die Leiterplatte aufgebracht. Das Aufbringen der Schicht erfolgt durch Plasmaabscheidung, vorzugsweise aus einem Kohlenwasserstoffgas, wie Methan oder Ethylen, in einem mit Radiofrequenz angeregten Niederdruckplasma mit einer dem Hochfrequenzfeld überlagerten self bias-DC-Spannung.

Bei Metallkernleiterplatten mit Löchern bzw. Bohrungen ist es vorteilhaft, diese leicht konisch auszuführen, damit auch die Wandungen relativ gleichmäßig mit a-C:H beschichtet werden können. Der grundsätzliche Vorteil von Metallkernleiterplatten, nämlich die Maßhaltigkeit der Kontaktlöcher, wird durch die konturengetreue dünne a-C:H-Beschichtung nicht beeinträchtigt. Der Aufbau der metallischen Leitbahnstrukturen auf den plasmaabgeschiedenen a-C:H-Schichten kann im übrigen mittels Additiv- oder Subtraktivtechnik erfolgen.

Der Metallkern der Leiterplatten nach der Erfindung besteht vorzugsweise aus Stahl oder Aluminium. Bei Leiterplatten mit einem Metallkern aus Aluminium ist es vorteilhaft, die Oberfläche des Metallkerns mit einer Eloxalschicht zu versehen, d.h. - vor der a-C:H-Abscheidung - elektrolytisch zu oxidieren. Die Eloxalschicht weist dabei vorzugsweise eine Dicke von ca. 1 μm auf.

Durch die Kombination einer dünnen Eloxalschicht (ca. 1 μm) mit einer stärkeren a-C:H-Schicht (ca. 5 μm) kann ein zweilagiger Aufbau realisiert werden mit einer - gegenüber a-C:H - verbesserten Spannungsfestigkeit, allerdings auf Kosten einer etwas reduzierten, im Vergleich zu Aluminiumoxidkeramik aber immer noch wesentlich besseren Wärmeleitung. Dabei wirkt sich ferner vorteilhaft aus, daß Poren und etwaige feine Risse in der Eloxalschicht durch die darüber angeordnete a-C:H-Schicht gegen eine Metallisierung geschützt sind und sich somit keine durchschlagsgefährdenden Metallspitzen durch die beiden Teilschichten hindurch ausbilden können.

Anhand eines Ausführungsbeispiels soll die Erfindung noch näher erläutert werden.

In eine Apparatur zur Plasmaabscheidung von a-C:H mittels RF-Anregung in Form eines zylindrischen Glasgefäßes wird Methan ($CH_4$) als Reaktionsgas bei einem Druck von 100 Pa eingeleitet. Das Reaktionsgas gelangt in das sich zwischen zwei ungleichen Elektroden (Flächenverhältnis 1:6) ausbildende Plasma mit einem Volumen von ca. 400 cm³; die beiden Elektroden sind dabei mit einem RF-Generator verbunden (13,56 MHz). Aufgrund der ungleichen Elektroden entsteht zwischen diesen eine - sich der RF-Spannung überlagernde - self bias-DC-Spannung, wobei die kleinere Elektrode, welche die zu beschichtenden Substrate, d.h. die Metallkernleiterplatten, trägt, zur Kathode wird.

Bei einer Hochfrequenz-Leistungsdichte von ca. 2,4 W/cm², bezogen auf die Kathodenfläche, entsteht zwischen den beiden Elektroden eine self bias-DC-Spannung von ca. 550 V. Unter diesen Bedingungen erhält man bei einem $CH_4$-Massedurchfluß von $8,8.10^4$ Pa.cm³.s$^{-1}$ auf der Metalloberfläche nach 30 min (Abscheiderate: ca. 3 nm/s) eine ca. 5 μm dicke a-C:H-Schicht mit einem intrinsischen elektrischen Widerstand > $10^{12}$ Ω.cm, bei einer Wärmeleitfähigkeit > 1 W/m.K und einer Durchschlagsfestigkeit > 100 V/μm.

**Patentansprüche**

1.　Metallkernleiterplatte mit einer wärmeableitenden Isolierschicht, **dadurch gekennzeichnet,** daß die Isolierschicht eine plasmaabgeschiedene Schicht aus amorphem wasserstoffhaltigem Kohlenstoff (a-C:H) ist.

2.　Metallkernleiterplatte nach Anspruch 1, **dadurch gekennzeichnet,** daß die Schicht aus amorphem wasserstoffhaltigem Kohlenstoff eine Dicke bis zu 5 μm aufweist.

3.　Metallkernleiterplatte nach Anspruch 1 oder 2, **dadurch gekennzeichnet,** daß der Metallkern aus Stahl besteht.

4.　Metallkernleiterplatte nach Anspruch 1 oder 2, **dadurch gekennzeichnet,** daß der Metallkern aus Aluminium besteht.

5.　Metallkernleiterplatte nach Anspruch 4, **dadurch gekennzeichnet,** daß die Oberfläche des Metallkerns mit einer Eloxalschicht versehen ist.

6.　Metallkernleiterplatte nach Anspruch 5, **dadurch gekennzeichnet,** daß die Eloxalschicht eine Dicke von ca. 1 μm aufweist.